# EUROPEAN PATENT APPLICATION

(11) **EP 4 625 496 A1**
(43) Date of publication of application: **01.10.2025**
(21) Application number: 23894924.2
(22) Date of filing: 16.11.2023
(51) Int. Cl.: H01L 27/146, H04N 25/70

(54) **IMAGE SENSING DEVICE, ELECTRONIC DEVICE COMPRISING SAME, AND IMAGE SENSING METHOD**

(30) Priority: 25.11.2022 KR 20220159953
(71) Applicant: LX Semicon Co., Ltd., Daejeon 34027 (KR)
(72) Inventor: JANG, Hoon, Daejeon 34027 (KR)
(74) Representative: Ter Meer Steinmeister & Partner
(86) International application number: PCT/KR2023/018422
(87) International publication number: WO 2024/111995

(57) **Abstract**

An image sensing device according to an aspect of the present disclosure includes a substrate on which a photodiode generating charge according to incident light is disposed, a first gate disposed on the substrate to overlap the photodiode so that a portion of a region in which the photodiode is disposed is exposed, and first and second photo gates disposed on the substrate not to overlap the photodiode to receive the charge moved by the first gate.

## Description

### Technical Field

The present disclosure relates to an image sensing device, an electronic device including the same, and an image sensing method.

### Background Art

An image sensor is a device that converts an optical image into an electrical signal. With the recent development of computer and communication industries, the demand for image sensors has been increasing in various fields such as digital cameras, camcorders, personal communication systems (PCSs), game devices, security cameras, medical micro cameras, and robots.

Representative schemes for measuring a depth using such an image sensor include triangulation, time of flight (hereinafter referred to as ToF), and interferometry schemes, and among these, the ToF scheme has a wide range of utilization and a high processing speed, and is advantageous in terms of costs. Such a ToF-based image sensor measures a time until a pulse-shaped optical signal radiated from a light source is reflected by an object and returns, and calculates a distance to the object to create an image of a depth of the object. As the optical signal output from the light source, for example, a microwave, a light wave, or an ultrasonic wave can be used.

### Disclosure

### Technical Problem

An object of the present disclosure is to provide an image sensing device in which an additional gate is disposed on a photodiode in addition to a photo gate to transfer charge generated by the photodiode, an electronic device including the same, and an image sensing method.

### Technical Solution

According to an aspect of the present disclosure, there is provided an image sensing device including a substrate on which a photodiode generating charge according to incident light is disposed, a first gate disposed on the substrate to overlap the photodiode so that a portion of a region in which the photodiode is disposed is exposed, and first and second photo gates disposed on the substrate not to overlap the photodiode to receive the charge moved by the first gate.

According to another aspect of the present disclosure, there is provided an image sensing method including receiving, by a photo gate, charge generated by a photodiode, storing, by a charge transfer circuit, the charge received by the photo gate, and outputting, by an output circuit, a pixel signal using the charge stored by the charge transfer circuit, wherein, in the receiving, a first voltage having a first voltage level is applied to a first gate disposed on the photodiode to overlap the photodiode and a third voltage having a third voltage level higher than the first voltage level is applied to the photo gate so that the charge is transferred from the first gate to the photo gate.

According to another aspect of the present disclosure, there is provided an electronic device including an image sensing device configured to emit an optical signal and generate a pixel signal using the optical signal reflected from an object, and a processor configured to calculate a distance to the object using the pixel signal, wherein the image sensing device includes a pixel array having a plurality of pixels generating the pixel signal using the optical signal reflected from the object, and wherein the pixel includes: a substrate on which a photodiode generating charge according to the optical signal is disposed, a first gate disposed on the substrate to overlap the photodiode so that a portion of a region in which the photodiode is disposed is exposed, and a photo gate disposed on the substrate not to overlap the photodiode and receiving charge moved by the first gate.

### Advantageous Effects

According to the present disclosure, by additionally disposing a first gate capable of receiving the charge from the photodiode on the photodiode, the size of the photo gate can be minimized and a pixel size can be reduced, thereby miniaturizing the image sensing device,.

Further, according to the present disclosure, by disposing the first gate on the photodiode to form a vertical structure with the photodiode, the charge generated by the photodiode can easily move to a surface of the substrate.

Further, according to the present disclosure, by patterning the first gate in a ring shape so that a region of a portion of the substrate on which the photodiode is disposed can be exposed, an overlapping region between the first gate and the photodiode can be reduced, and thus a driving load can be decreased since a capacitance formed between the photodiode and the first gate and an RC delay due to the capacitance can be decreased, thereby driving the image sensing device at a high driving frequency and improving depth measurement accuracy.

Further, according to the present disclosure, by additionally disposing a second gate on the photodiode to be surrounded by the first gate, charge generated in a photodiode positioned below a closed region formed by the first gate on the plane can be easily transferred to the first gate.

Further, according to the present disclosure, by applying the first voltage having the first voltage level to the first gate and applying the second voltage having the second voltage level lower than the first voltage level to the second gate, the charge generated in the photodiode can be effectively transferred from the second gate to the first gate, thereby minimizing an amount of residual charge that is not transferred from the photodiode to the photo gate.

Further, according to the present disclosure, a potential difference between the first gate and the second gate can be maximized by applying a positive voltage to the first gate and a negative voltage to the second gate, thereby maximizing efficiency of charge transfer from the second gate to the first gate.

### Description of Drawings

The accompanying drawings, which are included to provide a further understanding of the disclosure and are incorporated in and constitute a part of this application, illustrate embodiments of the disclosure and together with the description serve to explain the principle of the disclosure. In the drawings:
FIG. 1 is a block diagram of an electronic device including an image sensing device according to an embodiment of the present disclosure;
FIG. 2 is a plan view of a pixel array included in the image sensing device according to the embodiment of the present disclosure;
FIG. 3 is a plan view of a pixel included in the image sensing device according to the embodiment of the present disclosure;
FIG. 4 is a circuit diagram of the pixel included in the image sensing device according to the embodiment of the present disclosure;
FIG. 5A is a cross-sectional view of the pixel taken along line A-B in FIG. 3;
FIG. 5B is a cross-sectional view of the pixel taken along line X-X' in FIG. 3;
FIG. 6 is a plan view of a pixel included in an image sensing device according to another embodiment of the present disclosure;
FIG. 7 is a flowchart showing a method of driving the image sensing device according to the embodiment of the present disclosure;
FIG. 8 is a signal timing diagram according to the method of driving the image sensing device according to the embodiment of the present disclosure; and
FIGS. 9A to 9F illustrate voltages applied in respective modes and movement of charge in the method of driving the image sensing device according to the embodiment of the present disclosure.

### Mode for Invention

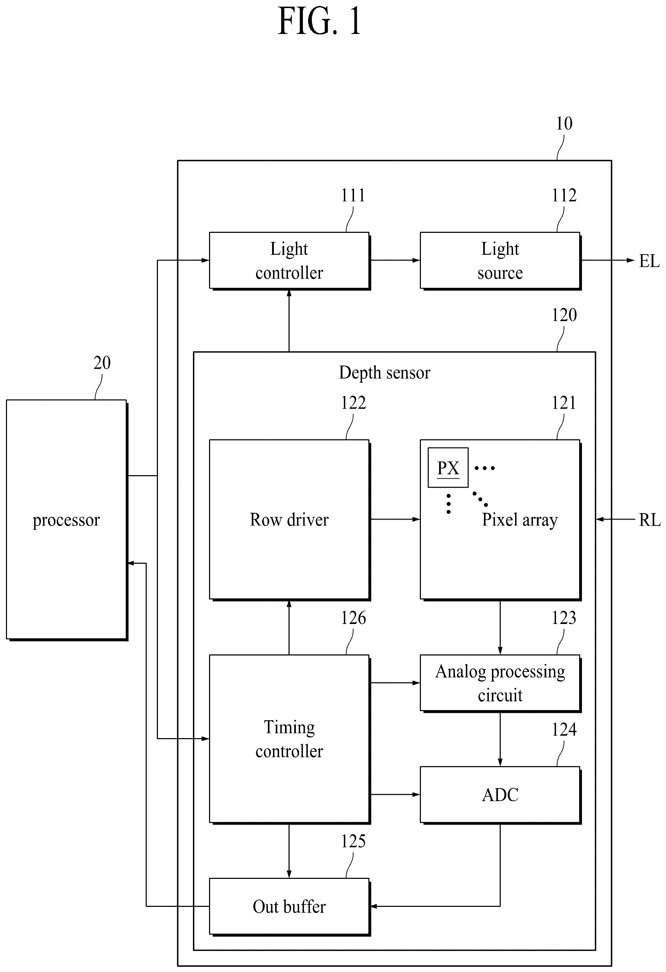

FIG. 1 is a block diagram of an electronic device including an image sensing device according to an embodiment of the present disclosure. As illustrated in FIG. 1, the electronic device according to the embodiment of the present disclosure can include an image sensing device 10 and a processor 20.

Using time of flight (ToF) technology, the image sensing device 10 can emit an optical signal EL to an object, receive an optical signal RL reflected from the object, and detect a distance between the image sensing device 10 and the object based on the optical signal RL. Hereinafter, for convenience of the description, the optical signal EL emitted from the image sensing device 10 to the object is referred to as a first optical signal EL, and the optical signal RL reflected from the object and incident on the image sensing device 10 is referred to as a second optical signal RL.

As illustrated in FIG. 1, the image sensing device 10 can include a light controller 111, a light source 112, and a depth sensor 120.

The light controller 111 can control the light source 112 under the control of the processor 20. Specifically, the light controller 111 can modulate the first optical signal EL with a predetermined frequency and phase, and the light source 112 can emit the modulated first optical signal EL. For example, the modulated first optical signal EL can have the form of a square wave (pulse) or a sinusoidal wave, and can be an infrared wave, microwave, light wave, or ultrasonic wave. For example, the light source 112 can include a light emitting diode (LED), a laser diode (LD), or an organic LED (OLED).

The depth sensor 120 generates pixel data by using the second optical signal RL received when the first optical signal EL emitted from the light source 112 is reflected from the object. To this end, the depth sensor 120 can include the pixel array 121, a row driver 122, an analog processing circuit 123, an analog-to-digital converter 124, an output buffer 125, and a timing controller 126.

The pixel array 121 includes a plurality of pixels PX. The pixels PX can generate, store, transfer, or remove the charge based on control signals provided from the row driver 122 to convert the second optical signal RL reflected from the object into a pixel signal, which is an electrical signal.

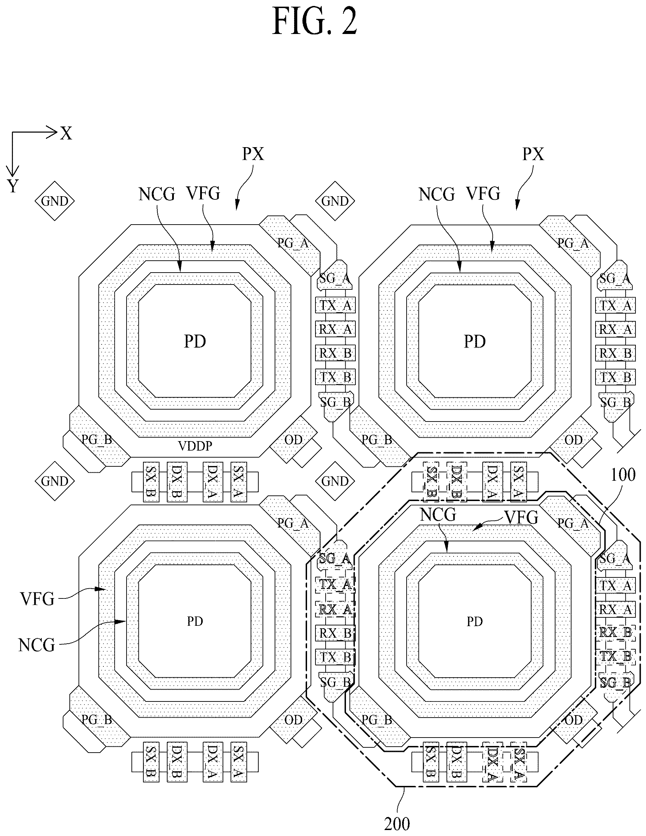

Hereinafter, a configuration of the pixel array 121 according to the present disclosure will be described with reference to FIG. 2. FIG. 2 is a plan view of the pixel array included in the image sensing device according to the embodiment of the present disclosure.

As illustrated in FIG. 2, the pixels PX included in the pixel array 121 can be arranged in a matrix form in an X direction and a Y direction. In FIG. 2, for convenience of description, the pixel array 121 is illustrated as including four pixels PXs, but this is only an example, and the number of pixels PXs constituting the pixel array 121 and an arrangement form of the pixels PXs can be changed in various ways.

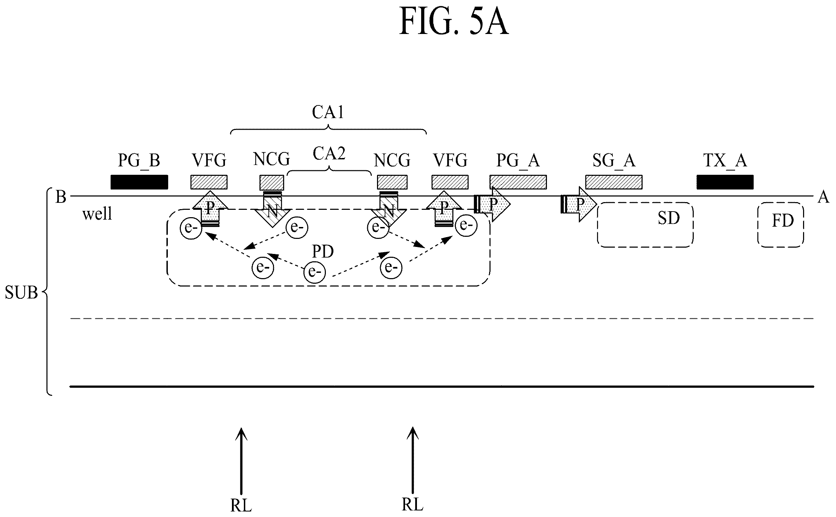

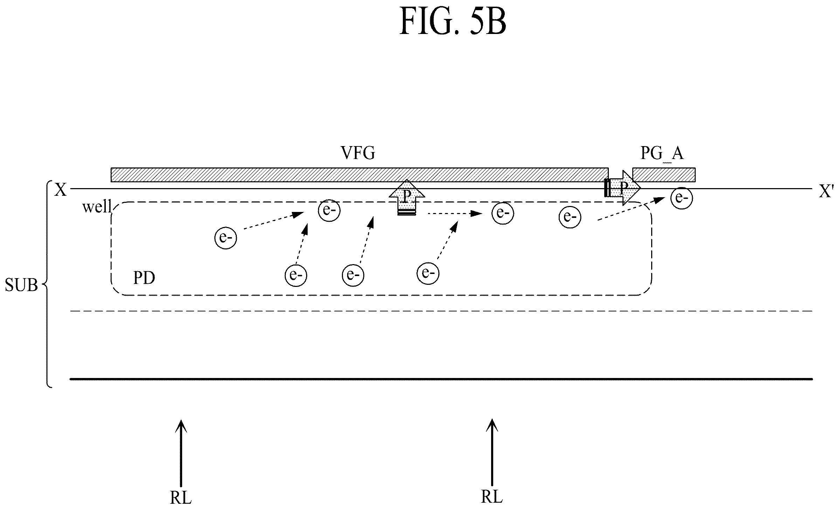

The pixel array 121 can be disposed inside a substrate SUB (see FIGS. 5A and 5B) or on the substrate SUB. In an embodiment, the substrate SUB can be a silicon substrate or a semiconductor substrate. For example, the substrate SUB can be a silicon substrate or a semiconductor substrate that is not doped with a dopant, a silicon substrate or a semiconductor substrate doped with at least one of an n-type dopant and a p-type dopant, or a silicon substrate or a semiconductor substrate including a well region doped with at least one of an n-type dopant and a p-type dopant.

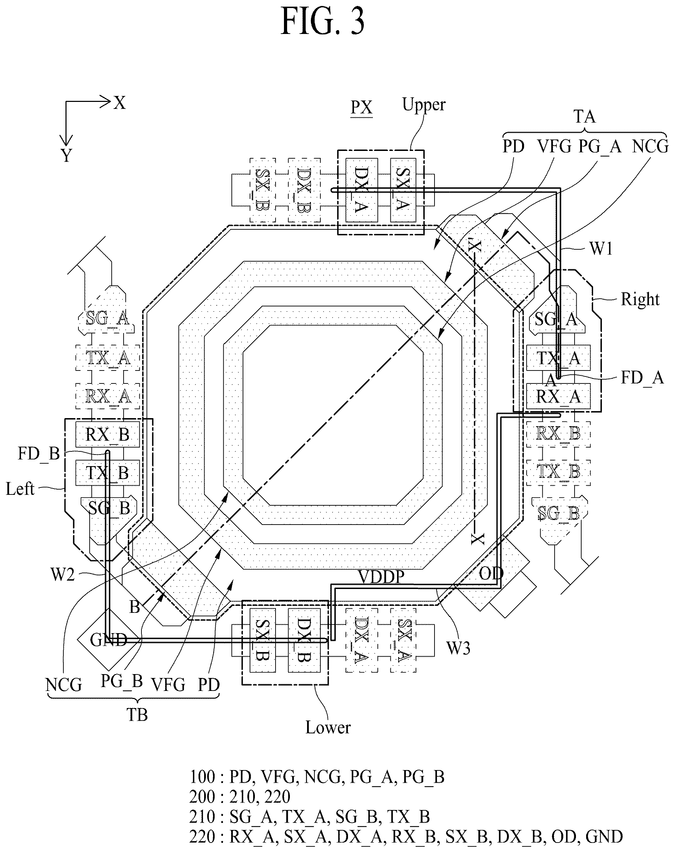

Each of the pixels PXs constituting the pixel array 121 can include a photoelectric conversion element 100 and a pixel control circuit 200. The photoelectric conversion element 100 generates charge according to the second optical signal RL reflected from the object. The pixel control circuit 200 stores, transfers, or removes the charge generated in the photoelectric conversion element 100 to generate a pixel signal based on control signals provided from the row driver 122. This will be described in detail with reference to FIG. 3.

Referring back to FIG. 1, the row driver 122 can drive the pixel array 121 under the control of the timing controller 126. The row driver 122 can control all the pixels PXs of the pixel array 121 simultaneously or control the pixels PXs of the pixel array 121 in units of rows. To this end, the row driver 122 can transfer the control signal to the pixels PXs.

In an embodiment, the row driver 122 can generate a reset control signal RST for resetting the pixels PXs, a storage control signal STG for storing the charge generated in the pixels PXs, a transfer control signal TRG for transferring the charge generated in the pixels PXs, and a selection control signal SEL for outputting a pixel signal under the control of the timing controller 126. The row driver 122 can transfer the reset control signal RST, the storage control signal STG, the transfer control signal TRG, and the selection control signal SEL to the pixels PXs.

The analog processing circuit 123 can receive, sample, and hold the pixel signal output from each of the pixels PXs constituting the pixel array 121. The analog processing circuit 123 can be connected to each pixel PX of the pixel array 121 to perform a correlated double sampling (CDS) operation on the pixel signal and remove noise included in the pixel signal.

The analog-to-digital converter 124 can convert the pixel signal processed by the analog processing circuit 123 into pixel data, which is a digital signal. The analog-to-digital converter 124 can provide the pixel data to the output buffer 125. Although the analog processing circuit 123 and the analog-to-digital converter 124 are illustrated as independent components in FIG. 1, the analog-to-digital converter 124 can be included in or integrated with the analog processing circuit 123 in other embodiments.

The output buffer 125 can store the pixel data transferred from the analog-to-digital converter 124. The output buffer 125 can output the pixel data to the processor 20.

The timing controller 126 can control the depth sensor 120. Specifically, the timing controller 126 can control the pixel array 121 through the row driver 122 and output control signals for controlling the analog processing circuit 123, the analog-to-digital converter 124, and the output buffer 125.

The processor 20 can control the image sensing device 10. The processor 20 can control the timing controller 126 so that the light controller 111 outputs the first optical signal EL at a predetermined frequency and with a predetermined phase, and control the depth sensor 120 so that the depth sensor 120 detects the second optical signal RL reflected from the object and generates the pixel data.

The processor 20 can calculate a distance between the image sensing device 10 and the object (for example, a ToF value), a shape of the object, a moving speed of the object, and the like based on the frequency and phase of the first optical signal EL emitted from the light source 112 and the pixel data generated by the depth sensor 120.

For example, the processor 20 can calculate a phase difference between the first optical signal EL emitted from the light source 112 and the second optical signal RL reflected from the object based on the pixel data generated by the depth sensor 120, and calculate a delay time of the second optical signal RL reflected from the object from the first optical signal EL emitted from the light source 112 using the calculated phase difference.

The processor 20 can include an image signal processor (ISP; not illustrated) for processing the pixel data transferred from the depth sensor 120. The processor 20 can also be referred to as a host, a sensor controller, or the like. For example, the processor 20 can be implemented separately from the image sensing device 10, as illustrated in FIG. 1. However, the present disclosure is not limited thereto, and the processor 20 can also be implemented to be integrated with the image sensing device 10.

The image sensing device 10 and the processor 20 according to the embodiment of the present disclosure can be included in an electronic device such as a robot cleaner, a medical device, an automobile, or a distance measurement device.

Hereinafter, the pixels PXs of the image sensing device 10 according to the embodiment of the present disclosure will be described in detail with reference to FIGS. 3 to 6.

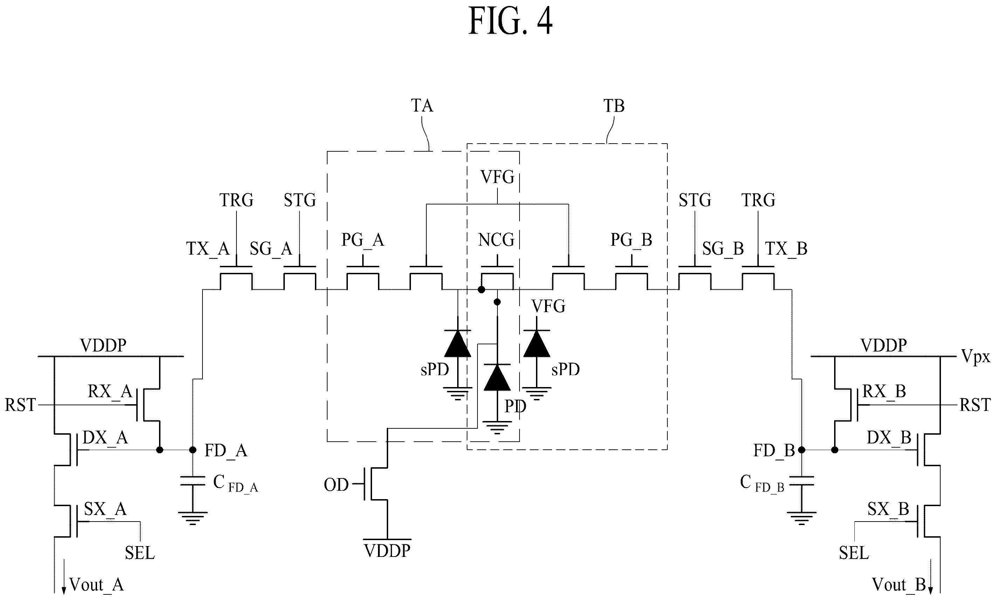

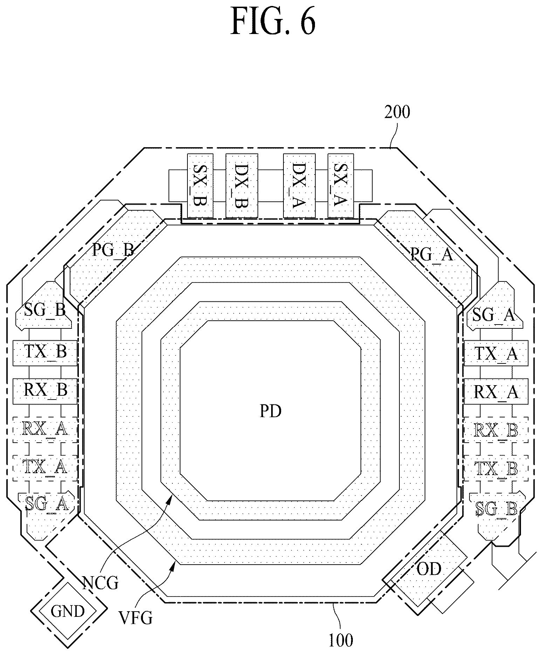

FIG. 3 is a plan view of the pixel included in the image sensing device according to the embodiment of the present disclosure. FIG. 4 is a circuit diagram of the pixel included in the image sensing device according to the embodiment of the present disclosure. FIG. 5A is a cross-sectional view of the pixel taken along line A-B in FIG. 3. FIG. 5B is a cross-sectional view of the pixel taken along line X-X' in FIG. 3. FIG. 6 is a plan view of a pixel included in an image sensing device according to another embodiment of the present disclosure.

The pixel PX can be any one of the pixels PXs constituting the pixel array 121 illustrated in FIG. 2. For convenience of description, the one pixel PX will be described by way of example hereinafter, but substantially the same structure and operation as those of the pixel illustrated in FIG. 3 can be applied to any of the pixels PXs included in the pixel array 121.

Referring to FIG. 3, the pixel PX can include a photoelectric conversion element 100 and a pixel control circuit 200 as described above. The pixel control circuit 200 can include a charge transfer circuit 210 and an output circuit 220.

The photoelectric conversion element 100 can generate and accumulate charge in response to the second optical signal RL reflected from the object. According to an embodiment of the present disclosure, the photoelectric conversion element 100 can include a photodiode PD, a first gate VFG, a first photo gate PG_A, and a second photo gate PG_B. Further, the photoelectric conversion element 100 can further include a second gate NCG.

According to an embodiment of the present disclosure, the photoelectric conversion element 100 generates the charge in response to the second optical signal RL reflected from the object and transfers the charge to the charge transfer circuit 210 to be described later. In an embodiment, the photoelectric conversion element 100 can be formed in a 2-tap structure driven by a first tap TA and a second tap TB. Specifically, as illustrated in FIGS. 3 and 4, the first tap TA can include a photodiode PD, a first gate VFG, a second gate NCG, and a first photo gate PG_A, and the second tap TB can include a photodiode PD, a first gate VFG, a second gate NCG, and a second photo gate PG_B.

In the 2-tap structure, two taps that generate charge and transfer the charge to the charge transfer circuit 210 transfer charge generated according to the received second optical signal RL with phases of 0° and 180° to the charge transfer circuit 210, and transfer charge generated according to the received second optical signal RL with phases of 90° and 270° to the charge transfer circuit 210. For example, the first photo gate PG_A of the first tap TA can transfer the charge generated according to the second optical signal RL with the phases of 0° and 180° to the charge transfer circuit 210 connected to the first tap TA, and the second photo gate PG_B of the second tap TB can transfer the charge generated according to the second optical signal RL with the phases of 90° and 270° to the charge transfer circuit 210 connected to the second tap TB.

Further, according to an embodiment of the present disclosure, the first tap TA and the second tap TB can be driven alternately in a charge generation section, which will be described below. For example, a process in which the charge generated in the photodiode PD is transferred to the charge transfer circuit 210 connected to the first tap TA through the first tap TA and a process in which the charge generated in the photodiode PD is transferred to the charge transfer circuit 210 connected to the second tap TB through the second tap TB can be performed alternately. In this case, the first tap TA and the second tap TB can be driven alternately while being toggled according to a predetermined frequency. However, the present disclosure is not limited thereto, and the first tap TA and the second tap TB can also be driven alternately once.

According to an embodiment of the present disclosure, the photodiode PD, the first gate VFG, and the second gate NCG can be shared between the first tap TA and the second tap TB. Accordingly, when the first tap TA and the second tap TB are alternately driven in the charge generation section, the pixel signal is generated using the charge generated using the entire area of each of the photodiode PD, the first gate VFG, and the second gate NCG, and thus the pixel signal can be generated using a larger amount of charge when the respective taps are driven, thereby improving the resolution of the pixel signal.

The photodiode PD generates the charge according to the second optical signal RL reflected from the object.

The photodiode PD can be formed by the doping of a portion of a well region of the substrate SUB, as illustrated in FIG. 5. For example, the photodiode PD can be formed in the well region doped with a P-type impurity. However, the present disclosure is not limited thereto and the photodiode PD can also be formed in the well region doped with an N-type impurity.

As illustrated in FIG. 3, the photodiode PD can be formed to have a polygonal shape on the plane. Specifically, the photodiode PD can have a polygonal shape with chamfered corners, and the first photo gate PG_A and the second photo gate PG B can be positioned on the outer regions of sides of the photodiode PD formed by the chamfering.

In an embodiment, the first photo gate PG_A and the second photo gate PG_B can be formed not to overlap the photodiode PD on the plane. This can reduce the size of a capacitor formed between the first photo gate PG_A and the photodiode PD when the first photo gate PG_A overlaps the photodiode PD, and the size of a capacitor formed between the second photo gate PG_B and the photodiode PD when the second photo gate PG_B overlaps the photodiode PD. Thus, an RC delay that can be caused by the capacitor formed between the first photo gate PG_A and the photodiode PD and the capacitor formed between the second photo gate PG_B and the photodiode PD can be reduced, a driving load of the pixel PX can be reduced, the first photo gate PG_A and the second photo gate PG B can be driven at a high frequency, and the measurement accuracy of the depth sensor 120 can be improved.

Further, according to the present disclosure, since the first gate VFG is additionally formed on the photodiode PD to prevent the efficiency of charge transfer from being degraded due to the first and second photo gates PG_A and PG_B being formed not to overlap the photodiode PD, it is possible to miniaturize the first and second photo gates PG_A and PG_B. Thus, it is possible to reduce the size of the pixel PX, thereby miniaturizing the image sensing device 10, or it is possible to increase the number of pixels PX per unit area, thereby improving the sensing accuracy.

The first gate VFG is formed on a portion of the substrate SUB in which the photodiode PD is formed. Specifically, as illustrated in FIGS. 3, 5A, and 5B, the first gate VFG is positioned to overlap the photodiode PD on the plane, so that the photodiode PD and the first gate VFG form a vertical structure. This allows an electric field to be formed perpendicular to the photodiode PD due to a first voltage applied to the first gate VFG, so that charge adjacent to a first surface of the substrate SUB on which the second optical signal RL is incident can be easily moved to a second surface of the substrate SUB.

In an embodiment, in order to reduce an overlapping area between the photodiode PD and the first gate VFG on the plane, the first gate VFG can be patterned so that a portion of the substrate SUB in which the photodiode PD is formed can be exposed to the outside. In this case, the reason for reducing the overlapping area between the photodiode PD and the first gate VFG is that capacitance formed between the photodiode PD and the first gate VFG is reduced as described above. Since the first gate VFG is formed to overlap a portion of the photodiode PD, a region of the photodiode PD that does not overlap the first gate VFG can be exposed to the outside.

In an embodiment, the first gate VFG can be formed in a ring shape with respect to a center of the photodiode PD on the plane. Since the first gate VFG is formed in a ring shape, it is possible to reduce the overlapping area between the first gate VFG and the photodiode PD. Although the first gate VFG is illustrated as having a quadrilateral ring shape with each chamfered corner in FIG. 3, this is only an example and the first gate VFG can be formed in a polygonal ring shape or a circular ring shape.

As illustrated in FIGS. 3 and 5b, the first gate VFG can be formed in an integral ring shape that is not segmented. Accordingly, since an electric field is uniformly formed in a region of the photodiode PD overlapping the first gate VFG, charge can be easily moved within the region of the photodiode PD overlapping the first gate VFG. For example, when the first gate VFG has an integral ring shape as described above, charge positioned far from the first photo gate PG_A can easily move to an area adjacent to the first photo gate PG_A within the electric field uniformly formed in a region of the photodiode PD overlapping the first gate VFG.

Meanwhile, the first gate VFG can be formed in a shape having a symmetrical structure with respect to the center of the photodiode PD on the plane. Accordingly, the first gate VFG can form the electric field symmetrically with respect to the center of the photodiode PD inside the photodiode PD. Specifically, when the first gate VFG is formed in an integral ring shape with respect to the center of the photodiode PD on the plane, a symmetrical electric field is formed in a ring shape with respect to the center of the photodiode PD in the photodiode PD positioned below a closed region CA1 defined by the first gate VFG, so that electric field uniformity can be improved.

According to an embodiment of the present disclosure, the first gate VFG can be formed to surround the second gate NCG to be described later on the plane. For example, the first gate VFG can be formed such that a length from the center of the photodiode PD to the first gate VFG is larger than a length from the center of the photodiode PD to the second gate NCG. In this case, the first gate VFG can be formed at a predetermined distance from the second gate NCG.

In an embodiment, a first voltage having at a first voltage level can be applied to the first gate VFG. In this case, the first voltage level can be higher than a level of a threshold voltage of the photodiode PD and can have a positive value. In particular, when the second optical signal RL reflected from the object and incident on the photodiode PD has a long wavelength, charge is generated on the lower side of the photodiode PD, and thus, in order to more effectively move the charge generated on the lower side of the photodiode PD to the upper side of the photodiode PD, the first voltage having the first voltage level higher than that of the threshold voltage of the photodiode PD can be applied to the first gate VFG.

The second gate NCG is formed on a region of a portion of the substrate SUB in which the photodiode PD is formed. Specifically, as illustrated in FIGS. 3, 5A, and 5B, the second gate NCG is positioned to overlap the photodiode PD on the plane. In this case, the second gate NCG can be formed to have a smaller area than the photodiode PD within the closed region CA1 defined by the first gate VFG on the plane. That is, the second gate NCG is formed in a shape in which the second gate NCG is surrounded by the first gate VFG on the plane.

In the present disclosure, the reason for forming the second gate NCG within the closed region CA1 defined by the first gate VFG is that charge generated at the center of the photodiode PD on the plane is efficiently moved toward the first gate VFG because it is difficult for the charge generated at the center of the photodiode PD on the plane to move to the first gate VFG due to a large distance to the first gate VFG.

In an embodiment, in order to reduce an overlapping area between the photodiode PD and the second gate NCG on the plane, the second gate NCG can be patterned so that the region of the portion of the substrate SUB in which the photodiode PD is formed can be exposed to the outside.

In this case, the reason for reducing the overlapping area between the photodiode PD and the second gate NCG is that capacitance formed between the photodiode PD and the second gate NCG is reduced as described above. Since the second gate NCG is formed to overlap the portion of the photodiode PD, the region of the photodiode PD that does not overlap the second gate NCG can be exposed to the outside.

In an embodiment, the second gate NCG can be formed in a ring shape with respect to the center of the photodiode PD on the plane. Since the second gate NCG is formed in the ring shape, the overlapping area between the second gate NCG and the photodiode PD can be reduced, and since the second gate NCG is formed in the ring shape that is not segmented, the charge generated in the photodiode PD can be transferred to the first gate VFG through an entire region of the second gate NCG.

In FIG. 3, the second gate NCG is illustrated as having a quadrilateral ring shape with each chamfered corner, but this is only one example and the second gate NCG can be formed in a polygonal ring shape or a circular ring shape. As another example, the second gate NCG can be formed in a filled circular shape.

Meanwhile, the second gate NCG can be formed in a shape having a symmetrical structure with respect to the center of the photodiode PD on the plane. Accordingly, the second gate NCG can form an electric field symmetrically with respect to the center of the photodiode PD inside the photodiode PD. Specifically, since a symmetrical electric field with respect to the center of the photodiode PD is formed in a ring shape on the plane in the photodiode PD positioned below a closed region CA2 defined by the second gate NCG when the second gate NCG is formed in a ring shape with respect to the center of the photodiode PD on the plane, electric field uniformity can be improved.

Since the second gate NCG is formed in a shape in which the second gate NCG is surrounded by the first gate VFG on the plane, the second gate NCG can be formed so that a length from the center of the photodiode PD to the second gate NCG is smaller than a length from the center of the photodiode PD to the first gate VFG. In this case, the second gate NCG can be formed at a predetermined distance from the first gate VFG.

A second voltage having a second voltage level lower than the first voltage level can be applied to the second gate NCG. When the second voltage is applied, an electric field is formed in the photodiode PD positioned below the closed region CA2 defined by the second gate NCG so that the charge generated according to the second optical signal RL in the photodiode PD can be moved from the second gate NCG toward the first gate VFG.

In an embodiment, the second voltage level can be lower than a level of the threshold voltage of the photodiode PD and can have a negative value. In the present disclosure, the reason for setting the second voltage level to be negative is that the charge can be more easily transferred from the second gate NCG to the first gate VFG due to an increase in a potential difference between the first gate VFG and the second gate NCG.

In the pixel circuit diagram illustrated in FIG. 4, the first and second gates VFG and NCG have been illustrated as transistors, but this is only an example, the first gate VFG can be implemented by any circuit element other than a transistor as long as the circuit element can apply the first voltage having the first voltage level, and the second gate NCG can be implemented by any circuit element other than a transistor as long as the circuit element can apply the second voltage having the second voltage level.

The first photo gate PG_A and the second photo gate PG_B can control the transfer of the charge generated in the photodiode PD. Specifically, when the first photo gate PG_A or the second photo gate PG B is turned on, the charge generated in the photodiode PD can be transferred to the charge transfer circuit 210, and when the first photo gate PG_A and the second photo gate PG_B are turned off, the transfer of the charge generated in the photodiode PD can be blocked.

In this case, the first photo gate PG_A and the second photo gate PG B can be turned on according to an applied third voltage having a third voltage level higher than the first voltage level. Thus, the third voltage having the third voltage level higher than the first voltage level is applied to the first photo gate PG_A and the second photo gate PG_B, which receive the charge generated in the photodiode PD through the first gate VFG and the second gate NCG and store the received charge in the charge transfer circuit 210. That is, the charge generated in the photodiode PD is transferred to the first and second photo gates PG_A and PG_B through the second gate NCG and the first gate VFG due to a potential difference between the photodiode PD, the second gate NCG, the first gate VFG, the first photo gate PG_A, and the second photo gate PG_B.

The first photo gate PG_A and the second photo gate PG_B can be positioned on the outer regions of the sides of the photodiode PD formed by chamfering on the plane as described above. Specifically, as illustrated in FIG. 3, the first photo gate PG_A and the second photo gate PG_B can be formed on the outer regions of sides facing diagonally with the photodiode PD interposed therebetween on the plane among the sides of the photodiode PD formed by chamfering. Alternatively, as another example, the first photo gate PG_A and the second photo gate PG_B can be formed on the outer regions of sides adjacent to each other in the X direction on the plane among the sides of the photodiode PD formed by chamfering, as illustrated in FIG. 6.

In FIG. 6, the first photo gate PG_A and the second photo gate PG_B are formed on the outer regions of the sides adjacent to each other in the X direction on the plane among the sides of the photodiode PD formed by chamfering, but the present disclosure is not limited thereto and the first photo gate PG_A and the second photo gate PG_B can be formed on the outer regions of the sides adjacent to each other in the Y direction.

According to an embodiment of the present disclosure, the first photo gate PG_A and the second photo gate PG_B can be positioned not to overlap the photodiode PD on the plane. Accordingly, it is possible to minimize the sizes of the capacitor formed between the first photo gate PG_A and the photodiode PD and the capacitor formed between the second photo gate PG_B and the photodiode PD, and thus to reduce an RC delay that can occur due to the capacitor formed between the first photo gate PG_A and the photodiode PD and the capacitor formed between the second photo gate PG_B and the photodiode PD. Thus, with the present disclosure, it is possible to reduce the driving load of the pixel PX so that the first photo gate PG_A and the second photo gate PG_B can be driven at a high frequency, thereby improving the measurement accuracy of the depth sensor 120.

According to an embodiment of the present disclosure, each of the first photo gate PG_A and the second photo gate PG_B can have a smaller area than the photodiode PD on the plane. Specifically, each of the first photo gate PG_A and the second photo gate PG_B can have an area smaller than the photodiode PD on the plane and have an area larger than or the same as each gate of the plurality of transistors included in the pixel control circuit 200. The reason for reducing the size of the first and second photo gates PG_A and PG_B in the present disclosure is that the first and second gates VFG and NCG capable of moving the charge generated by the photodiode PD to the first and second photo gates PG_A and PG_B are additionally formed on the photodiode PD.

According to an embodiment of the present disclosure, as described above, since the first tap TA and the second tap TB are alternately driven, the first photo gate PG_A of the first tap TA and the second photo gate PG_B of the second tap TB can be alternately driven. That is, the charge generated in the photodiode PD can be alternately stored in the charge transfer circuits 210 connected to the first photo gate PG_A and the second photo gate PG_B through the first photo gate PG_A and the second photo gate PG_B. For example, a process of transferring the charge generated in the photodiode PD through the first photo gate PG_A and a process of transferring the charge generated in the photodiode PD through the second photo gate PG_B can be alternately performed according to a predetermined frequency. To this end, the first photo gate PG_A and the second photo gate PG_B can be driven by being toggled according to a predetermined frequency. However, the present disclosure is not limited thereto, and the first photo gate PG_A and the second photo gate PG_B can also be alternately driven once.

The pixel control circuit 200 can be positioned on at least one side of the photoelectric conversion element 100, as illustrated in FIG. 3. A plurality of transistors and wirings W1, W2, and W3 for electrically connecting the plurality of transistors can be positioned in the pixel control circuit 200 in order to convert the charge stored by the first tab TA and the second tab TB into an electric signal. Specifically, the pixel control circuit 200 includes the charge transfer circuit 210 and the output circuit 220.

The charge transfer circuit 210 stores the charge transferred through the first and second photo gates PG_A and PG_B and then transfers the charge to the output circuit 220. To this end, the charge transfer circuit 210 can include a plurality of transistors. According to an embodiment of the present disclosure, the charge transfer circuit 210 can include a first storage transistor SG_A and a first transfer transistor TX_A electrically connected to the first tap TA, and a second storage transistor SG_B and a second transfer transistor TX_B electrically connected to the second tap TB.

As illustrated in FIG. 3, the charge transfer circuits 210 can be positioned in a right region Right and a left region Left of the photoelectric conversion element 100. Specifically, the first storage transistor SG_A and the first transfer transistor TX_A connected to the first photo gate PG_A can be positioned in the right region of the photoelectric conversion element 100, and the second storage transistor SG_B and the second transfer transistor TX_B connected to the second photo gate GP_B can be positioned in the left region Left of the photoelectric conversion element 100.

The first storage transistor SG_A is turned on according to the storage control signal STG received from the row driver 122 to temporarily store the charge transferred from the first photo gate PG_A. The second storage transistor SG_B is turned on according to the storage control signal STG transferred from the row driver 122 to temporarily store the charge transferred from the second photo gate PG_B.

The first transfer transistor TX_A is turned on according to the transfer control signal TRG received from the row driver 122 to transfer the charge stored in the first storage transistor SG_A to the first floating diffusion capacitor CFD_A. In this case, the first floating diffusion capacitor CFD_A can be formed in an area of the substrate SUB corresponding to a first floating diffusion node FD_A. The second transfer transistor TX_B can be turned on according to the transfer control signal TRG received from the row driver 122 to thereby transfer the charge stored in the second storage transistor SG_B to the second floating diffusion capacitor CFD_B. In this case, the second floating diffusion capacitor CFD_B can be formed in an area of the substrate SUB corresponding to a second floating diffusion node FD_B.

The output circuit 220 outputs a pixel signal using the charge transferred from the charge transfer circuit 210. To this end, the output circuit 220 can include a plurality of transistors. According to an embodiment of the present disclosure, the output circuit 220 includes a first reset transistor RX_A, a first source follower transistor DX_A, and a first selection transistor SX_A electrically connected to the first tap TA, a second reset transistor RX_B, a second source follower transistor DX_B, and a second selection transistor SX_B electrically connected to the second tap TB, and an overflow transistor OD electrically connected to the first tap TA and the second tap TB.

The plurality of transistors included in the output circuit 220 can be distributed and disposed in the right region Right, the left region Left, the upper region Upper, and the lower region Lower of the photoelectric conversion element 100, as illustrated in FIG. 3. Specifically, the first reset transistor RX_A can be disposed below the first transfer transistor TX_A in the Y direction in the right region Right of the photoelectric conversion element 100, and the first source follower transistor DX_A and the first selection transistor SX_A can be disposed in the X direction in the upper region Upper of the photoelectric conversion element 100. In this case, the first reset transistor RX_A is electrically connected to the first transfer transistor TX_A through the first floating diffusion node FD_A, and the first source follower transistor DX_A and the first selection transistor SX_A are connected to the first reset transistor RX_A through a first wiring W1.

Similarly, the second reset transistor RX_B can be disposed above the second transfer transistor TX_B in the Y direction in the left region Light of the photoelectric conversion element 100, and the second source follower transistor DX_B and the second selection transistor SX_B can be disposed in the X direction in the lower region Lower of the photoelectric conversion element 100. In this case, the second reset transistor RX_B is electrically connected to the second transfer transistor TX_B through the second floating diffusion node FD_B, and the second source follower transistor DX_B and the second selection transistor SX_B are connected to the second reset transistor RX_B through a second wiring W2.

In an embodiment, as illustrated in FIG. 3, the first storage transistor SG_A, the first transfer transistor TX_A, and the first reset transistor RX_A can be formed within the right region Right to be point-symmetrical with the second storage transistor SG_B, the second transfer transistor TX_B, and the second reset transistor RX_B with respect to the center of the photodiode PD.

Further, the first source follower transistor DX_A and the first selection transistor SX_A can be formed in the upper region Upper to be point-symmetrical with the second source follower transistor DX_B and the second selection transistor SX_B with respect to the center of the photodiode PD.

The first reset transistor RX_A is turned on according to the reset control signal RST received from the row driver 122, to thereby reset a potential of the first floating diffusion capacitor CFD_A to a reset voltage VDDP. The second reset transistor RX_B is turned on according to the reset control signal RST received from the row driver 122, to thereby reset a potential of the second floating diffusion capacitor CFD_B to the reset voltage VDDP. In this case, the first and second reset transistors RX_A and RX_B can receive the reset voltage VDDP through the third wiring W3, as illustrated in FIG. 3.

The first source follower transistor DX_A outputs a current corresponding to a potential of the first floating diffusion node FD_A as a reset signal or pixel signal to the first output signal line Vout_A. In this case, the potential of the first floating diffusion node FD_A varies depending on the charge stored in the first floating diffusion capacitor CFD_A as described above. The second source follower transistor DX_B outputs a current corresponding to a potential of the second floating diffusion node FD_B as a reset signal or a pixel signal to the second output signal line Vout_B. In this case, the potential of the second floating diffusion node FD_B varies depending on the charge stored in the second floating diffusion capacitor CFD_B as described above.

The first selection transistor SX_A is turned on according to the selection control signal SEL received from the row driver 122, to thereby output a reset signal or pixel signal output from the first source follower transistor DX_A to the first output signal line Vout_A, and the second selection transistor SX_B is turned on according to the selection control signal SEL received from the row driver 122, to thereby output a reset signal or pixel signal output from the second source follower transistor DX_B to the second output signal line Vout_B.

The overflow transistor OD is turned on to discharge charge remaining in the pixel or the charge that is generated in the photodiode PD due to unwanted external light.

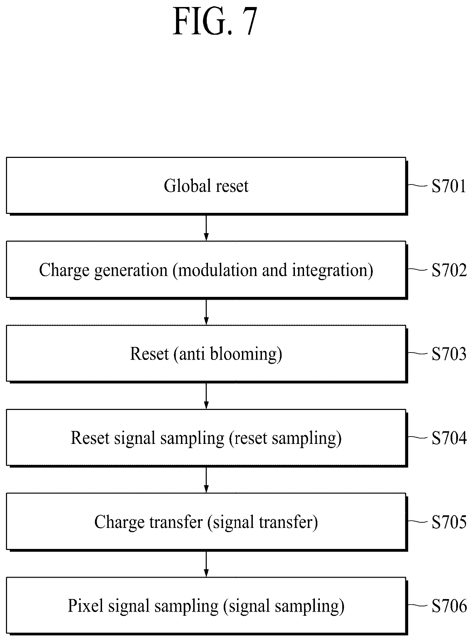

Hereinafter, a method of driving the image sensing device according to the embodiment of the present disclosure will be described in detail with reference to FIGS. 7 to 9.

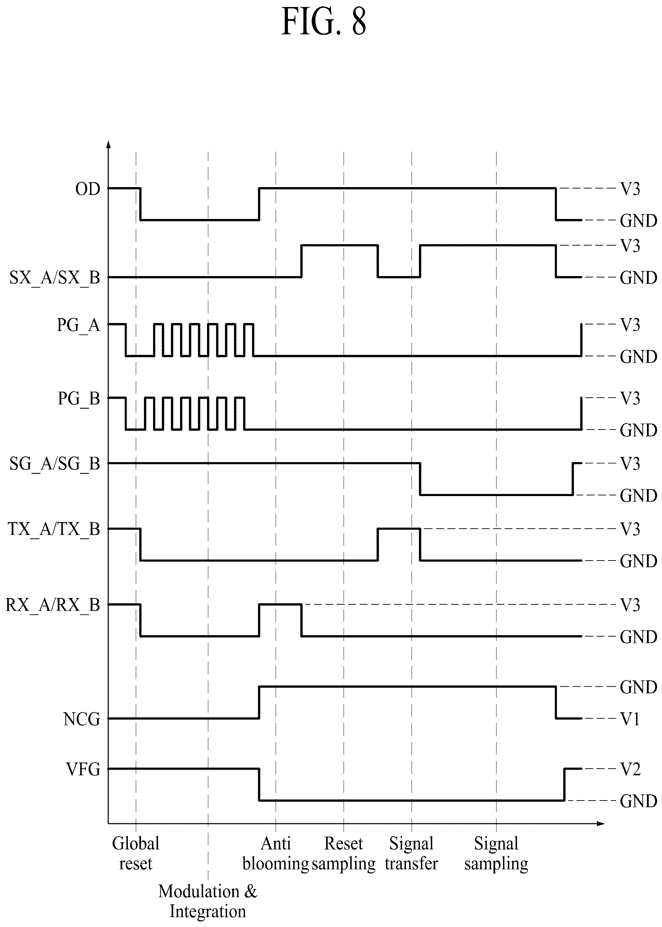

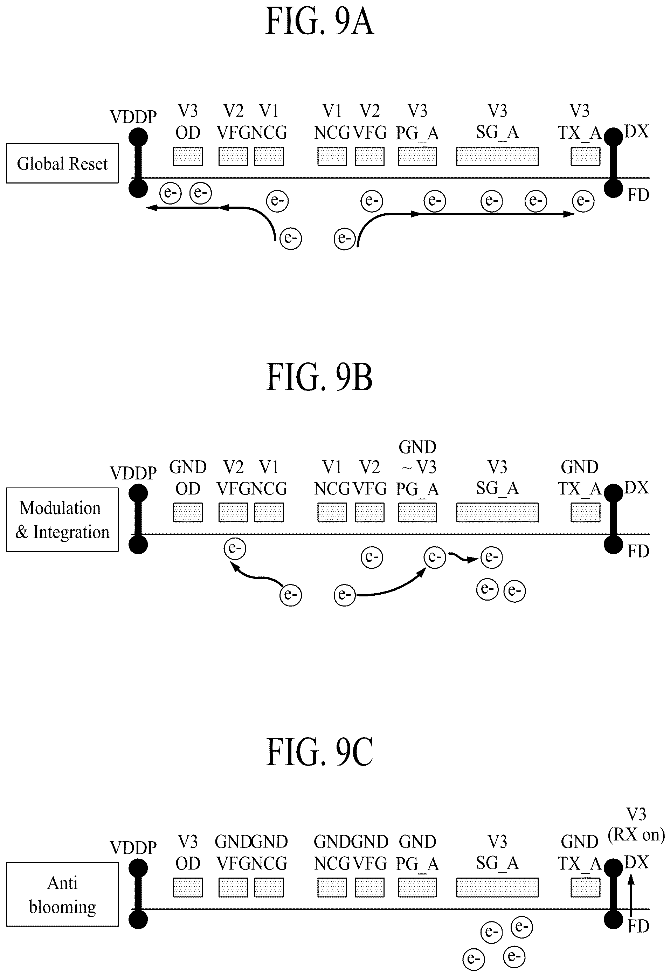

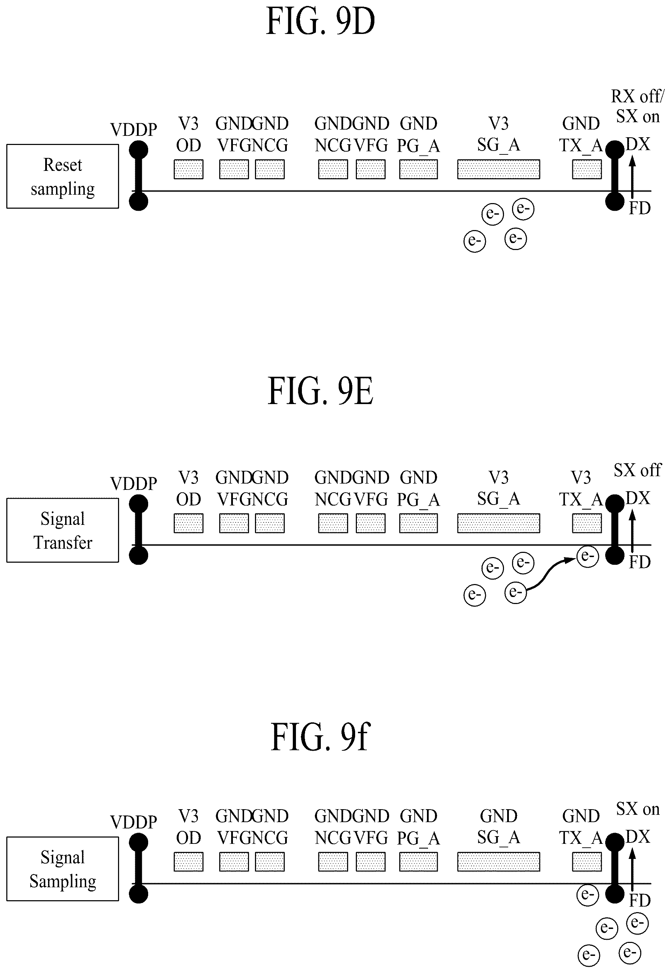

FIG. 7 is a flowchart showing a method of driving the image sensing device according to the embodiment of the present disclosure. FIG. 8 is a signal timing diagram according to the method of driving the image sensing device according to the embodiment of the present disclosure. FIGS. 9A to 9F are diagrams illustrating voltages applied in respective modes and movement of charge in the method of driving the image sensing device according to the embodiment of the present disclosure.

Referring to FIG. 7, the image sensing device according to the embodiment of the present disclosure is driven according to a global reset section S701 for resetting the pixels PXs of the pixel array 121, a charge generation section S702 for generating and storing charge according to the second optical signal RL, a reset section S703 for resetting the pixels to a predetermined reset voltage, a reset signal sampling section S704 for sampling a reset signal, a charge transfer section S705 for transferring the charge generated and stored according to the second optical signal RL, and a pixel signal sampling section S706 for sampling a pixel signal generated according to the transferred charge, to thereby generate a pixel signal using the second optical signal RL.

In the global reset section S701, the image sensing device removes remaining charge of all the pixels PXs included in the pixel array 121 to reset the pixels PX. Specifically, in the global reset section, as illustrated in FIGS. 8 and 9A, a first voltage V1 at a first voltage level is applied to the first gate VFG included in each pixel, a second voltage V2 at a second voltage level lower than the first voltage level is applied to the second gate NCG, and a third voltage V3 at a third voltage level higher than the first voltage level is applied to the first and second photo gates PG_A and PG_B, so that charge generated due to unwanted external light or charge remaining in the photodiode PD is transferred to the first and second photo gates PG_A and PG_B.

Further, since the overflow transistor OD, the first and second storage transistors SG_A and SG_B, the first and second transfer transistors TX_A and TX_B, and the first and second reset transistors RX_A and RX_B are all turned on, the charge transferred by the first and second photo gates PG_A and PG_B and the charge stored in capacitors formed in the pixels PX, such as the first and second floating diffusion capacitors CFD_A and CFD_B, are discharged through the overflow transistor OD, such that all the pixels PXs are reset.

In an embodiment, during the global reset section S701, the first voltage V1 at a positive level (for example, 0.7 V or 2.8 V) is applied to the first gate VFG so that the charge positioned on the lower side of the photodiode PD can easily move toward the surface of the substrate SUB. Further, since the second voltage V2 at the second voltage level (for example, 0 V or □1.0 V) lower than the first voltage level is applied to the second gate NCG so that an electric field is formed from the second gate NCG toward the first gate VFG, charge positioned at the center of the photodiode PD on the plane can be easily moved toward the first gate VFG. Further, since the third voltage V3 at the third voltage level (for example, 2.8 V) equal to or higher than the first voltage level is applied to the first photo gate PG_A and the second photo gate PG B so that an electric field is formed from the first gate VFG toward the first photo gate PG_A or from the first gate VFG toward the second photo gate PG_B, charge can be easily moved from the first gate VFG toward the first photo gate PG_A or the second photo gate PG_B.

In the charge generation section S702, the charge is generated according to the second optical signal RL incident on the photodiode PD, and the generated charge is moved to the first and second photo gates PG_A and PG_B through the second gate NCG and the first gate VFG inside the photodiode PD.

Specifically, in the charge generation section, the first voltage V1 is applied to the first gate VFG, and the second voltage V2 is applied to the second gate NCG, as illustrated in FIGS. 8 and 9B. Thus, the charge generated in the photodiode PD is moved from the second gate NCG to the first gate VFG due to an electric field formed by the first voltage V1 applied to the first gate VFG and the second voltage V2 applied to the second gate NCG.

Further, the first photo gate PG_A and the second photo gate PG_B are alternately turned on according to the applied third voltage V3 while being toggled at a predetermined frequency during the section. Accordingly, the charge moved to the first gate VFG is received through the first photo gate PG_A during a section in which the first photo gate PG_A is turned on, and the charge moved to the first gate VFG is received through the second photo gate PG_B during a section in which the second photo gate PG_B is turned on. In FIG. 8, the first photo gate PG_A and the second photo gate PG_B are illustrated as being driven alternately multiple times, but the present disclosure is not limited thereto and the first photo gate PG_A and the second photo gate PG_B can be driven alternately once.

Meanwhile, since the first and second storage transistors SG_A and SG_B remain on during the section, the charge moved to the first photo gate PG_A is stored in the first storage transistor SG_A, and the charge moved to the second photo gate PG_B is stored in the second storage transistor SG_B.

Since the overflow transistor OD remains off during the section, it is possible to prevent the charge generated in the photodiode PD from flowing out through the overflow transistor OD.

In the reset section S703, a predetermined reset voltage VDDP is applied to the first and second floating diffusion capacitors CFD_A and CFD_B, thereby resetting a potential of the pixel PX to a level of the reset voltage VDDP.

Specifically, in the reset section, as illustrated in FIGS. 8 and 9C, the first and second reset transistors RX_A and RX_B are turned on according to the reset control signal RST output from the row driver 122, so that the reset voltage VDDP is applied to the first and second floating diffusion nodes FD_A and FD_B. Further, since the first and second transfer transistors TX_A and TX_B remain off, the charge stored in the first and second storage transistors SG_A and SG_B cannot be transferred to the first and second floating diffusion nodes FD_A and FD_B. Accordingly, the first and second floating diffusion capacitors CFD_A and CFD_B connected to the first and second floating diffusion nodes FD_A and FD_B are charged with the reset voltage VDDP.

In the reset signal sampling section S704, currents corresponding to potentials of the first and second floating diffusion nodes FD_A and FD_B according to charging voltages of the first and second floating diffusion capacitors CFD_A and CFD_B are output as reset signals (which can also be referred to as reset voltages).

Specifically, in the reset signal sampling section, the first and second reset transistors RX_A and RX_B are turned off, and the first and second selection transistors SX_A and SX_B are turned on according to the selection control signal SEL. Accordingly, the current corresponding to the potential of the first floating diffusion node FD_A is output as the reset signal to the first output signal line Vout_A through the first source follower transistor DX_A and the first selection transistor SX_A. Further, the current corresponding to the potential of the second floating diffusion node FD_B is output as the reset signal to the second output signal line Vout_B through the second source follower transistor DX_B and the second selection transistor SX_B.

In the charge transfer section S705, the charge stored in the first and second storage transistors SG_A and SG_B is stored in the first and second floating diffusion capacitors CFD_A and CFD_B through the first and second transfer transistors TX_A and TX_B.

Specifically, in the charge transfer section, the first and second storage transistors SG_A and SG_B are turned on according to the storage control signal STG transferred from the row driver 122, and the first and second transfer transistors TX_A and TX_B are turned on according to the transfer control signal TRG transferred from the row driver 122. Accordingly, the charge stored in the first storage transistor SG_A is stored in the first floating diffusion capacitor CFD_A through the first transfer transistor TX_A. Further, the charge stored in the second storage transistor SG_B is stored in the second floating diffusion capacitor CFD_B through the second transfer transistor TX_B.

In the pixel signal sampling section S706, currents corresponding to potentials of the first and second floating diffusion nodes FD_A and FD_B according to the charge stored in the first and second floating diffusion capacitors CFD_A and CFD_B are output as pixel signals (which can also be referred to as pixel voltages).

Specifically, in the pixel signal sampling section, as illustrated in FIG. 8, the first and second transfer transistors TX_A and TX_B and the first and second storage transistors SG_A and SG_B are turned off so that the charge transfer to the first and second floating diffusion capacitors CFD_A and CFD_B through the first and second transfer transistors TX_A and TX_B is blocked. At the same time, since the first and second selection transistors SX_A and SX_B are turned on according to the selection control signal SEL transferred from the row driver 122, the current corresponding to the potential of the first floating diffusion node FD_A determined depending on the charge stored in the first floating diffusion capacitor CFD_A is output as a pixel signal to the first output signal line Vout_A through the first source follower transistor DX_A and the first selection transistor SX_A. Further, the current corresponding to the potential of the second floating diffusion node FD_B determined depending on the charge stored in the second floating diffusion capacitor CFD_B is output as a pixel signal to the second output signal line Vout_B through the second source follower transistor DX_B and the second selection transistor SX B.

Meanwhile, during the reset section S703, the reset signal sampling section S704, the charge transfer section S705, and the pixel signal sampling section S706 described above, the overflow transistor OD stays on to discharge the charge that is generated in the photodiode PD due to unwanted external light, thereby reducing noise generated due to remaining charge.

### Industrial Applicability

The present disclosure can be applicable to image sensors and various display devices, and thus has industrial applicability.

## Claims

1. An image sensing device comprising:
a substrate on which a photodiode generating charge according to incident light is disposed;
a first gate disposed on the substrate to overlap the photodiode so that a portion of a region in which the photodiode is disposed is exposed; and
first and second photo gates disposed on the substrate not to overlap the photodiode to receive the charge moved by the first gate.

2. The image sensing device of claim 1, wherein the first gate is disposed in a symmetrical structure with respect to a center of the photodiode or is disposed in an integral ring shape.

3. The image sensing device of claim 1, further comprising a second gate disposed on the substrate to overlap the photodiode,
wherein the second gate is disposed on the substrate to be surrounded by the first gate.

4. The image sensing device of claim 3, wherein
the second gate is disposed in an integral ring shape,
a first voltage having a first voltage level is applied to the first gate, and a second voltage having a second voltage level lower than the first voltage level is applied to the second gate so that the generated charge is moved from the second gate to the first gate, and
the first voltage level has a positive value and the second voltage level has a negative value.

5. The image sensing device of claim 1, wherein
a first voltage having a first voltage level is applied to the first gate, and a third voltage having a third voltage level higher than the first voltage level is applied to the first and second photo gates, so that the charge is moved from the first gate to the first and second photo gates, and
the sizes of the first and second photo gates is smaller than the size of the photodiode.

6. The image sensing device of claim 1,
wherein the photodiode has a polygonal shape with chamfered corners, and the first and second photo gates are respectively disposed on outer regions of sides formed by the chamfering on the substrate, and
wherein the first and second photo gates are disposed on outer regions of a first side and a second side, the first and the second sides being diagonally facing each other with the photodiode interposed therebetween, among the sides formed by the chamfering.

7. The image sensing device of claim 6, wherein the first and second photo gates are disposed on the outer regions of the first side and the third side adjacent to each other among the sides formed by the chamfering.

8. The image sensing device of claim 1, further comprising:
an output circuit configured to output a pixel signal using the generated charge; and
a charge transfer circuit configured to store the charge received by the first and second photo gates and transfer the stored charge to the output circuit,
wherein the first and second photo gates are alternately turned on when the charge is generated by the photodiode, the second photo gate is turned off when the first photo gate is turned on so that the generated charge is transferred to the charge transfer circuit through the first photo gate, and the first photo gate is turned off when the second photo gate is turned on so that the generated charge is transferred to the charge transfer circuit through the second photo gate.

9. A method of driving an image sensing device comprising:
receiving, by a photo gate, charge generated by a photodiode;
storing, by a charge transfer circuit, the charge received by the photo gate; and
outputting, by an output circuit, a pixel signal using the charge stored by the charge transfer circuit,
wherein, in the receiving, a first voltage having a first voltage level is applied to a first gate disposed on the photodiode to overlap the photodiode and a third voltage having a third voltage level higher than the first voltage level is applied to the photo gate so that the charge is transferred from the first gate to the photo gate.

10. An electronic device comprising
an image sensing device configured to emit an optical signal and generate a pixel signal using the optical signal reflected from an object; and
a processor configured to calculate a distance to the object using the pixel signal, wherein the image sensing device includes a pixel array having a plurality of pixels generating the pixel signal using the optical signal reflected from the object, and
wherein the pixel includes:
a substrate on which a photodiode generating charge according to the optical signal is disposed;
a first gate disposed on the substrate to overlap the photodiode so that a portion of a region in which the photodiode is disposed is exposed; and
a photo gate disposed on the substrate not to overlap the photodiode and receiving charge moved by the first gate.
